# EUROPEAN PATENT APPLICATION

(11) **EP 4 525 241 A1**
(43) Date of publication of application: **19.03.2025**
(21) Application number: 24154343.8
(22) Date of filing: 29.01.2024
(51) Int. Cl.: H02H 9/04, B60L 50/40

(54) **METHOD OF OVERVOLTAGE PROTECTION AND OVERVOLTAGE PROTECTION DEVICE USING THE SAME**

(30) Priority: 15.09.2023 US 202363538502 P; 29.12.2023 US 202318399689
(71) Applicant: Bamboo Dynamics Corporation., Ltd., Jubei, Hsinchu 302058 (TW)
(72) Inventor: CHAN, Yuan Chen, Hsinchu 302058 (TW); CHUANG, Chi-Ming, Hsinchu City 300060 (TW)
(74) Representative: Becker, Eberhard

(57) **Abstract**

A method of overvoltage protection and an overvoltage protection device are provided. The method includes: electrically connecting an input terminal of a one-way pass circuit to a first equipment and electrically connecting an output terminal of the one-way pass circuit to a second equipment; electrically connecting a converter to the output terminal and a supercapacitor; detecting a first voltage of a first power flow at the output terminal by the converter; and charging the supercapacitor by the first power flow in response to the first voltage being greater than a first threshold.

## Description

### BACKGROUND

### Technical Field

The disclosure is directed to a method of overvoltage protection and an overvoltage protection device.

### Description of Related Art

Logistics automation is a precise process where different motors in a conveyor system may stop or start at different times. When a motor stops suddenly, the voltage on the power line may surge and cause damage to the power line or to the motor controller. Dedicated power supplies for motors may have built-in protection to prevent voltage surges from returning to the equipment, while the voltage surge to the motor controller can be avoided by configuring more gentle stops. However, there are cases when these adjustments are not practical, such as when existing power supplies without built-in protection are used or when urgent motor braking is necessary. Therefore, a separate protector device against power surges is needed.

### SUMMARY

The disclosure is directed to a method of overvoltage protection and an overvoltage protection device. The disclosure may protect an equipment from voltage surge according to a voltage detection result.

The disclosure is directed to an overvoltage protection device, including a one-way pass circuit, a supercapacitor, and a converter. The one-way pass circuit including an input terminal electrically connected to a first equipment and an output terminal electrically connected to a second equipment. The converter is electrically connected to the output terminal and the supercapacitor, wherein the converter detects a first voltage of a first power flow at the output terminal, and charges the supercapacitor by the first power flow in response to the first voltage being greater than a first threshold.

In one embodiment of the disclosure, the converter discharges the supercapacitor in response to a second voltage stored by the supercapacitor being greater than a second threshold.

In one embodiment of the disclosure, the converter discharges the supercapacitor in response to a third voltage at the output terminal being less than a third threshold, wherein the third threshold is less than or equal to the first threshold.

In one embodiment of the disclosure, the third threshold is greater than a fourth voltage of a second power flow provided by the first equipment.

In one embodiment of the disclosure, the converter provides a third power flow to the second equipment via the output terminal by discharging the supercapacitor.

In one embodiment of the disclosure, the converter converts the third power flow discharged by the supercapacitor from the second voltage to the third voltage, and provides the converted third power flow to the second equipment, wherein the third voltage is greater than the second voltage.

In one embodiment of the disclosure, the converter converts the first power flow from the first voltage to a fifth voltage, and charges the supercapacitor by the converted first power flow, wherein the fifth voltage is less than the first voltage.

In one embodiment of the disclosure, the first equipment including a power supply and the second equipment including a motor.

The disclosure is directed to a method of overvoltage protection, including: electrically connecting an input terminal of a one-way pass circuit to a first equipment and electrically connecting an output terminal of the one-way pass circuit to a second equipment; electrically connecting a converter to the output terminal and a supercapacitor; detecting a first voltage of a first power flow at the output terminal by the converter; and charging the supercapacitor by the first power flow in response to the first voltage being greater than a first threshold.

According to the above description, the present disclosure may protect an equipment from the voltage surges by simply configuring the overvoltage protection device between the power supply and the equipment.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 illustrates a schematic diagram of an overvoltage protection device according to one embodiment of the disclosure.
FIG. 2 illustrates a flowchart of a method of overvoltage protection according to one embodiment of the disclosure.

### DESCRIPTION OF THE EMBODIMENTS

In order to make the disclosure more comprehensible, several embodiments are described below as examples of implementation of the disclosure. Moreover, elements/components/steps with the same reference numerals are used to represent identical or similar parts in the figures and embodiments where appropriate.

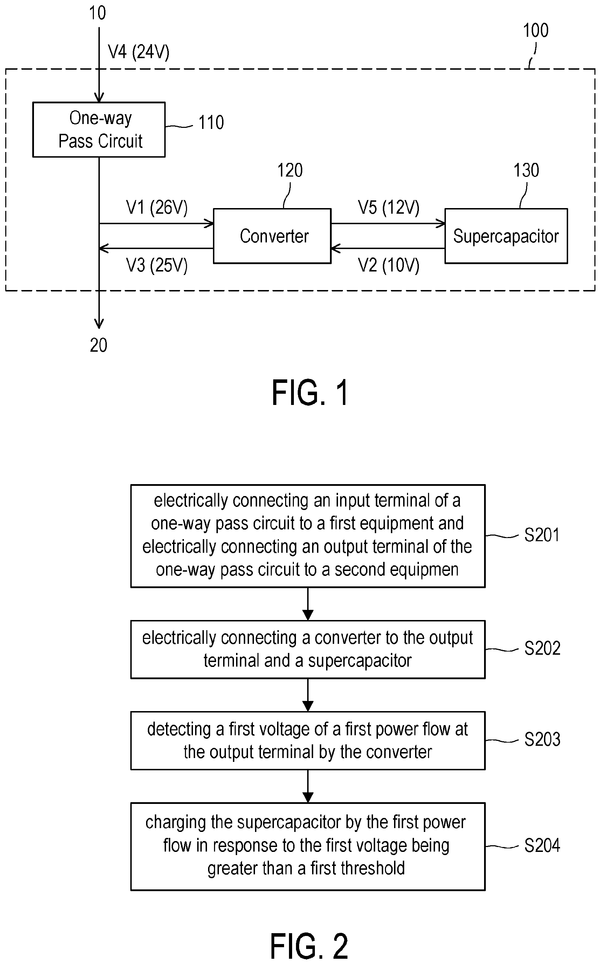

FIG. 1 illustrates a schematic diagram of an overvoltage protection device 100 according to one embodiment of the disclosure. The overvoltage protection device 100 may be configured between the equipment 10 and the equipment 20, wherein the equipment 10 may include a power supply and the equipment 20 may include an electrical load such as a motor or a motor control card. The overvoltage protection device 100 may protect the equipment 10 from voltage surge damage caused by the stopping of the equipment 20.

The overvoltage protection device 100 may include a one-way pass circuit 110, a converter 120, and a supercapacitor 130. The input terminal of the one-way pass circuit 110 may electrically connect to the equipment 10 and the output terminal of the one-way pass circuit 110 may electrically connect to the equipment 20. The one-way pass circuit 110 may limit the direction of signals (e.g., power flow, current, or voltage) such that the signals can only be transmitted from the equipment 10 to the equipment 20. The signals from the equipment 20 cannot be transmitted to the equipment 10 through the one-way pass circuit 110. When a voltage surge occurs in the powered equipment 20, the power surge cannot pass through the one-way pass circuit 110. In one embodiment, the one-way pass circuit 110 may be implemented by an ORing diode.

The converter 120 may include a bidirectional direct current (DC) to DC converter. The converter 120 may be configured between the output terminal of the one-way pass circuit 110 and the supercapacitor 130 and may electrically connect to the output terminal of the one-way pass circuit 110 and to the supercapacitor 130.

The converter 120 may detect voltage V1 of a power flow at the output terminal of the one-way pass circuit 110. If voltage V1 is greater than a first threshold (e.g., 26V), e.g., due to power surge caused by the stopping of the equipment 20, the converter 120 may convert the voltage of the power flow from voltage V1 to voltage V5, and the converter 120 may direct the converted power flow to the supercapacitor 130 to charge the supercapacitor 130, wherein voltage V5 (e.g., 12V) may be less than voltage V1 (e.g., 26V). On the other hand, if voltage V1 is not greater than the first threshold, the converter 120 may not direct the power flow to the supercapacitor 130 and may not charge the supercapacitor 130.

In one embodiment, the converter 120 may detect voltage V2 stored by the supercapacitor 130. If voltage V2 is greater than a second threshold (e.g., 10V), the converter 120 may discharge the supercapacitor 130 and may provide the power flow discharged by the supercapacitor 130 to the equipment 20 via the output terminal of the one-way pass circuit 110. Specifically, the converter 120 may convert the power flow discharged by the supercapacitor 130 from voltage V2 to voltage V3, and may provide the converted power flow to the equipment 20, wherein voltage V3 (e.g., 25V) may be greater than voltage V2 (e.g., 10V).

In one embodiment, the converter 120 may detect voltage V3 at the output terminal of the one-way pass circuit 110. If voltage V3 is less than a third threshold (e.g., 26V), the converter 120 may discharge the supercapacitor 130 to provide a power flow to the equipment 20 through the output terminal of the one-way pass circuit 110, wherein the third threshold (e.g., 26V) may be less than or equal to the first threshold (e.g., 26). In one embodiment, the third threshold (e.g., 26V) may be greater than voltage V4 (e.g., 24V) of the power flow provided by the equipment 10.

FIG. 2 illustrates a flowchart of a method of overvoltage protection according to one embodiment of the disclosure, wherein the method may be implemented by the overvoltage protection device 100 as shown in FIG. 1. In step S201, electrically connecting an input terminal of a one-way pass circuit to a first equipment and electrically connecting an output terminal of the one-way pass circuit to a second equipment. In step S202, electrically connecting a converter to the output terminal and a supercapacitor. In step S203, detecting a first voltage of a first power flow at the output terminal by the converter. In step S204, charging the supercapacitor by the first power flow in response to the first voltage being greater than a first threshold.

In summary, the overvoltage protection device of the present disclosure may configure a one-way pass circuit between an equipment and a power supply. The overvoltage protection device may detect a voltage of the output terminal of the one-way pass circuit and may direct the power flow from the one-way pass circuit to a supercapacitor if the detected voltage is greater than a voltage threshold, so as to lower the voltage of the surge power. The supercapacitor may be charged accordingly. When the supercapacitor is no longer being charged and reaches its discharge voltage, the power may flow from the supercapacitor to the converter. The converter may raise the discharge voltage to a value higher than the voltage provided by the power supply. Thus, when an electrical load is established from the powered equipment, before the power from the power supply flows through the one-way pass circuit to the powered equipment, the power discharged from the supercapacitor may flow through the converter to the equipment to provide for the powered equipment. Therefore, the supercapacitor may not accumulate power but will undergo charge-discharge cycles.

## Claims

1. An overvoltage protection device (100), **characterised in that**, the overvoltage protection device comprising:
a one-way pass circuit (110), comprising an input terminal electrically connected to a first equipment (10) and an output terminal electrically connected to a second equipment (20);
a supercapacitor (130);
a converter (120), electrically connected to the output terminal and the supercapacitor (130), wherein the converter (120) detects a first voltage of a first power flow at the output terminal, and charges the supercapacitor (130) by the first power flow in response to the first voltage being greater than a first threshold.

2. The overvoltage protection device (100) according to claim 1, wherein the converter (120) discharges the supercapacitor (130) in response to a second voltage stored by the supercapacitor (130) being greater than a second threshold.

3. The overvoltage protection device (100) according to claim 2, wherein the converter (120) discharges the supercapacitor (130) in response to a third voltage at the output terminal being less than a third threshold, wherein the third threshold is less than or equal to the first threshold.

4. The overvoltage protection device (100) according to claim 3, wherein the third threshold is greater than a fourth voltage of a second power flow provided by the first equipment (10).

5. The overvoltage protection device (100) according to claim 2, wherein the converter (120) provides a third power flow to the second equipment (20) via the output terminal by discharging the supercapacitor (130).

6. The overvoltage protection device (100) according to claim 5, wherein the converter (120) converts the third power flow discharged by the supercapacitor (130) from the second voltage to the third voltage, and provides the converted third power flow to the second equipment (20), wherein the third voltage is greater than the second voltage.

7. The overvoltage protection device (100) according to claim 2, wherein the converter (120) converts the first power flow from the first voltage to a fifth voltage, and charges the supercapacitor (130) by the converted first power flow, wherein the fifth voltage is less than the first voltage.

8. The overvoltage protection device (100) according to claim 1, wherein the first equipment (10) comprising a power supply and the second equipment (20) comprising a motor.

9. A method of overvoltage protection, **characterised in that**, the method comprising:
electrically connecting an input terminal of a one-way pass circuit to a first equipment and electrically connecting an output terminal of the one-way pass circuit to a second equipment (S201);
electrically connecting a converter to the output terminal and a supercapacitor (S202);
detecting a first voltage of a first power flow at the output terminal by the converter (S203); and
charging the supercapacitor by the first power flow in response to the first voltage being greater than a first threshold (S204).
